# EUROPEAN PATENT APPLICATION

(11) **EP 3 872 854 A1**
(43) Date of publication of application: **01.09.2021**
(21) Application number: 20159811.7
(22) Date of filing: 27.02.2020
(51) Int. Cl.: H01L 23/40

(54) **POWER MODULE HOUSING WITH IMPROVED PROTRUSION DESIGN**

(71) Applicant: Littelfuse, Inc., Chicago, IL 60631 (US)
(72) Inventor: SPANN, Thomas, Chicago, IL Illinois 60631 (US)
(74) Representative: Arnold & Siedsma

(57) **Abstract**

Aspects of the present disclosure include one or more power semiconductor device modules. A power semiconductor module can include: a power terminal, a housing, a heatsink and a protrusion, wherein the housing includes a first tab, and a first protrusion, and wherein the first tab contacts the substrate, and the first protrusion contacts the heatsink.

## Description

### Background

### Field

Embodiments relate to the field of semiconductor devices, and in particular, protrusion useful in semiconductor packaging.

### Discussion of Related Art

Most power semiconductor devices like silicon-controlled rectifiers ("SCRs"), power transistors, insulated gate-bipolar transistors ("IGBTs"), metal-oxide-semiconductor field effect transistors ("MOSFETs"), bipolar power rectifiers, power regulators, or combinations thereof, are assembled in packages that fail to provide sufficient mechanical support or optimal thermal transfer capacities.

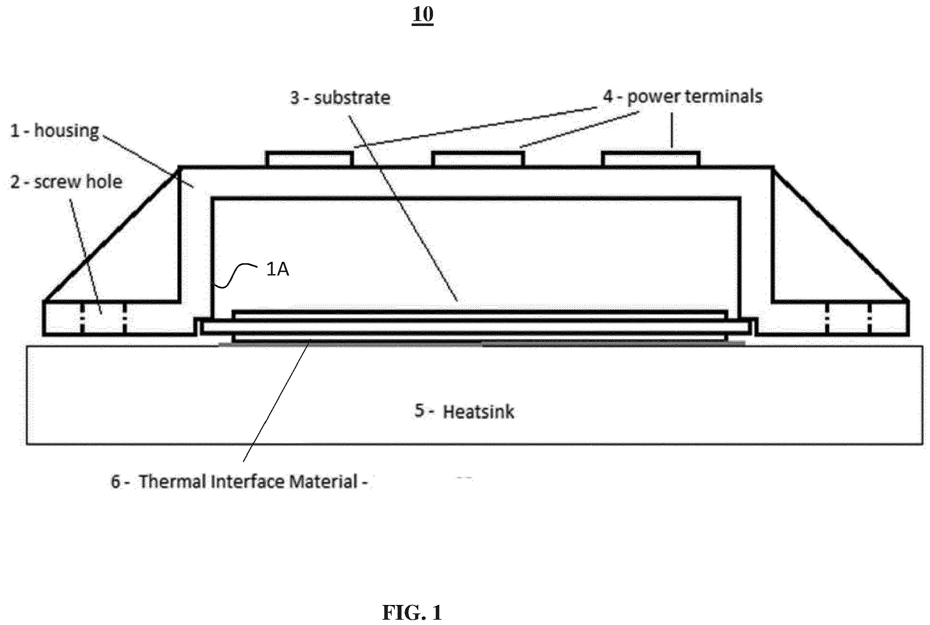

Fig. 1 illustrates a conventional power module device, shown as module 10, that includes a housing 1, a substrate 3, where in various embodiments the substrate 3 can have upper and lower surfaces being disposed in the housing 1, and upper and lower metallizations respectively disposed on the upper and lower surfaces of the substrate 3. In various embodiments, the housing 1 can be composed on any suitable material, including but not limited to epoxy, plastic, rubber, silicone, or similar materials. In various embodiments, the substrate can be composed of any materials suitable for direct copper bonding (DCB) and/or direct aluminum bonding (DAB). In various embodiments, the substrate 3 is mounted to a heatsink 5, where the heatsink 5 may be composed of any suitable material associated with conventional power modules. In various embodiments, the housing 1 has formations with holes, e.g. hole 2, for screws to fasten the module 10 on the heatsink 5. The housing 1 has one or more power terminals 4 in relation to the upper surface thereof, where the power terminals 4 can be installed using any suitable methodology associated with conventional power modules. In various embodiments, the one or more power terminals 4 can have screw holes (not shown), to be connected to exterior busbars (not shown), and dependent on the module application. In various embodiments, a thermal interface material 6, such as thermal grease, one or more thermal pads or a phase change material (PCM) can be at an interface between heatsink 5 and substrate 3. Various electrical components (not shown), e.g. thyristors, diodes, etc. an be contained in the housing 1 or otherwise associated with the module 10.

In view of the above, the present embodiments are provided.

### Brief Summary

At least one embodiment includes a power semiconductor device module. The at least one power semiconductor device module includes: a housing in contact with a substrate, a heatsink and a plurality of power terminals, where the housing includes a first tab and a first protrusion, extending substantially perpendicular to one another, and where the first protrusion contacts the heatsink and the first tab contacts the substrate.

Another one embodiment includes a power semiconductor device module. The at least one power semiconductor device module includes: a housing in contact with a substrate, a heatsink and a plurality of power terminals, where the housing includes a first tab and a first protrusion, substantially perpendicular to one another, and where the first protrusion contacts the heatsink and the first tab contacts the substrate, where the first protrusion is a heel.

Yet another one embodiment includes a power semiconductor device module. The at least one power semiconductor device module includes: a power terminal at least partially contained in a housing, where the power terminal contacts a substrate , where the housing includes a tab and a first protrusion, substantially perpendicular to one another, and where the first tab partially protrudes to an exterior portion of the housing, where the at least first protrusion contacts the heatsink, and the first tab contacts the housing. In various embodiments, the first protrusion is a heel.

Yet another one embodiment includes a power semiconductor device module. The at least one power semiconductor device module includes: a power terminal at least partially contained in a housing, where the power terminal contacts a substrate, where the housing includes a first tab and a first protrusion, substantially perpendicular to one another, and where the first tab partially protrudes to an exterior portion of the housing, where the first protrusion contacts the heatsink, and where the first tab contacts the housing. In various embodiments, the first protrusion is a heel, and where the plurality of power terminals are associated with an exterior portion of the housing.

Yet another one embodiment includes a power semiconductor device module. The at least one power semiconductor device module includes: a power terminal at least partially contained in a housing, where the power terminal contacts a substrate, where the housing includes a first protrusion and a first tab, substantially perpendicular to one another, and where the first tab partially protrudes to an exterior portion of the housing, where the first protrusion contacts the heatsink, and the first tab contacts the housing. In various embodiments, the first protrusion is a heel, where the plurality of power terminals are associated with an exterior portion of the housing, and where the substrate is associated with an interior portion of the housing.

Yet another one embodiment includes a power semiconductor device module. The at least one power semiconductor device module includes: a power terminal at least partially contained in a housing, where the power terminal contacts substrate, where the housing includes a first tab and a first protrusion, substantially perpendicular to one another, and where the first tab partially protrudes to an exterior portion of the housing, where the first protrusion contacts the heatsink, and where the first tab contacts the housing. In various embodiments, the first protrusion is a heel, where the plurality of power terminals are associated with an exterior portion of the housing, where the substrate is associated with an interior portion of the housing, and where a first screw connected through the first tab to the heatsink.

Yet another one embodiment includes a power semiconductor device module. The at least one power semiconductor device module includes: a power terminal at least partially contained in a housing, where the power terminal contacts a substrate, where the housing includes a first tab and a first protrusion, substantially perpendicular to one another, and where the first protrusion partially protrudes to an exterior portion of the housing, where the first protrusion contacts the heatsink, and where the first tab parts contacts the housing. In various embodiments, the first protrusion is a heel, where the plurality of power terminals are associated with an exterior portion of the housing, where the substrate is associated with an interior portion of the housing, and where a first screw connected through the first tab connecting the first tab to the heatsink, and where the housing includes a second tab.

Yet another one embodiment includes a power semiconductor device module. The at least one power semiconductor device module includes: a power terminal at least partially contained in a housing, where the power terminal contacts a substrate, where the housing includes a first tab and a first protrusion, substantially perpendicular to one another, and where the first tab partially protrudes to an exterior portion of the housing, where the first protrusion contacts the heatsink, and where the first tab contacts the housing. In various embodiments, the first protrusion is a heel, where the plurality of power terminals are associated with an exterior portion of the housing, where the substrate is associated with an interior portion of the housing, and where a first screw connected through the first tab to the heatsink, where the housing includes a second tab., and where the second tab is connected to an opposite portion of the housing in relation to the first tab.

Yet another one embodiment includes a power semiconductor device module. The at least one power semiconductor device module includes: a power terminal at least partially contained in a housing, where the power terminal contacts a substrate, where the housing includes a first tab and a first protrusion with at least two parts, substantially perpendicular to one another, and where the first tab partially protrudes to an exterior portion of the housing, where the first protrusion contacts the heatsink, and where the first tab contacts the housing. In various embodiments, the first protrusion is a heel, where the plurality of power terminals are associated with an exterior portion of the housing, where the substrate is associated with an interior portion of the housing, and where a first screw connected through the first tab to the heatsink, where the housing includes a second tab, where the second tab is connected to an opposite portion of the housing in relation to the first tab, and where the second tab is connected to a second protrusion.

Yet another one embodiment includes a power semiconductor device module. The at least one power semiconductor device module includes: a power terminal at least partially contained in a housing, where the power terminal contacts a substrate, where the housing includes a first tab and a first protrusion, substantially perpendicular to one another, and where the first tab partially protrudes to an exterior portion of the housing, where the first protrusion contacts the heatsink, and where the first tab contacts the housing. In various embodiments, the first protrusion is a heel, where the plurality of power terminals are associated with an exterior portion of the housing, where the substrate is associated with an interior portion of the housing, and where a first screw connects the first tab to the heatsink, where the housing includes a second tab, where the tab protrusion is connected to an opposite portion of the housing in relation to the first tab, where the second tab is connected to a second protrusion, substantially perpendicular in relation to one another.

Yet another one embodiment includes a power semiconductor device module. The at least one power semiconductor device module includes: a power terminal at least partially contained in a housing, where the power terminal contacts a substrate, where the housing includes a first tab and a first protrusion, substantially perpendicular to one another, and where the first tab partially protrudes to an exterior portion of the housing, where the first protrusion contacts the heatsink, and where the first tab parts contacts the housing. In various embodiments, the first protrusion is a heel, where the plurality of power terminals are associated with an exterior portion of the housing, where the substrate is associated with an interior portion of the housing, and where a first screw connects the first tab to the heatsink, where the housing includes a second tab, where the second tab is connected to an opposite portion of the housing in relation to the first tab, where the second tab is connected to a second protrusion, substantially perpendicular in relation to one another, and where the second protrusion is a heel.

Yet another one embodiment includes a power semiconductor device module. The at least one power semiconductor device module includes: a power terminal at least partially contained in a housing, where the power terminal contacts a substrate, where the housing includes a first tab and a first protrusion, substantially perpendicular to one another, and where the first tab partially protrudes to an exterior portion of the housing, where the first protrusion contacts the heatsink, and where the first tab contacts the housing. In various embodiments, the first protrusion is a heel, where the plurality of power terminals are associated with an exterior portion of the housing, where the substrate is associated with an interior portion of the housing, and where a first screw connected through the first tab to the heatsink, where the housing includes a second tab, where the second tab is connected to an opposite portion of the housing in relation to the first tab, where the second tab is connected to a second protrusion, where substantially perpendicular in relation to one another, where the second protrusion is a heel, and where the second protrusion contacts the heatsink.

Yet another one embodiment includes a power semiconductor device module. The at least one power semiconductor device module includes: a power terminal at least partially contained in a housing, where the power terminal contacts a substrate, where the housing includes a first tab and a first protrusion, substantially perpendicular to one another, and where the first tab partially protrudes to an exterior portion of the housing, where the first protrusion contacts the heatsink, and where the first tab parts contacts the housing. In various embodiments, the first protrusion is a heel, where the plurality of power terminals are associated with an exterior portion of the housing, where the substrate is associated with an interior portion of the housing, and where a first screw connected through the first tab to the heatsink, where the housing includes a second tab, where the second tab is connected to an opposite portion of the housing in relation to the first tab, where the second tab is connected to a second protrusion, where substantially perpendicular in relation to one another, where the second protrusion is a heel, where the second protrusion contacts the heatsink, and where the second tab contacts the substrate.

Yet another one embodiment includes a power semiconductor device module. The at least one power semiconductor device module includes: a power terminal at least partially contained in a housing, where the power terminal contacts a substrate, where the housing includes a first tab and a first protrusion, substantially perpendicular to one another, and where the first tab partially protrudes to an exterior portion of the housing, where the first protrusion contacts the heatsink, and where the first tab contacts the housing. In various embodiments, the first protrusion is a heel, where the plurality of power terminals are associated with an exterior portion of the housing, where the substrate is associated with an interior portion of the housing, and where a first screw connected through the first tab to the heatsink, where the housing includes a second tab, where the second tab is connected to an opposite portion of the housing in relation to the first tab, where the second tab is connected to a second protrusion, substantially perpendicular in relation to one another, where the second protrusion is a heel, where the second protrusion contacts the heatsink, and where the second tab contacts the substrate, and where a second screw connected through the second tab connects the second tab to the heatsink.

Yet another embodiment includes a method for configuring a power semiconductor device. The method can include: providing a housing with a first tab and a first protrusion, where the first protrusion is in contact with a heatsink and utilizing a first screw to connect the first tab to the heatsink, where the first tab and first protrusion extend substantially perpendicular to one another.

Yet another embodiment includes a method for configuring a power semiconductor device. The method can include: providing a housing with a first tab and a first protrusion, where the first protrusion is in contact with a heatsink, utilizing a first screw to connect the first tab a substrate disposed on the heatsink and the first protrusion to the heatsink, where the method can further include: utilizing a second screw to connect a second tab to the substrate, and a second protrusion to the heatsink, second tab and second protrusion extend substantially perpendicular to one another.

### Brief Description of the Drawings

**FIG. 1** shows a schematic of a conventional power semiconductor device module;
**FIG. 2** shows a schematic of a power semiconductor device module according to at least one embodiment of the present disclosure;
**FIG. 2B** shows a schematic of another power semiconductor device module according to at least one embodiment of the present disclosure;
**FIG.3** shows a method for affixing a protrusion to a housing and heatsink associated with a power semiconductor device module and according to at least one embodiment of the present disclosure.
**FIGs. 4A-4F** illustrate variants of a housing according to additional embodiments of the disclosure.
**FIG. 4G** illustrates a perspective view of a housing according to additional embodiments of the disclosure.

### Description of Embodiments

The present embodiments will now be described more fully hereinafter with reference to the accompanying drawings, in which exemplary embodiments are shown. The embodiments are not to be construed as limited to the embodiments set forth herein. Rather, these embodiments are provided so that this disclosure will be thorough and complete, and will fully convey their scope to those skilled in the art. In the drawings, like numbers refer to like elements throughout.

In the following description and/or claims, the terms "on," "overlying," "disposed on" and "over" may be used in the following description and claims. "On," "overlying," "disposed on" and "over" may be used to indicate that two or more elements are in direct physical contact with one another. Also, the term "on,", "overlying," "disposed on," and "over", may mean that two or more elements are not in direct contact with one another. For example, "over" may mean that one element is above another element while not contacting one another and may have another element or elements in between the two elements. Furthermore, the term "and/or" may mean "and", it may mean "or", it may mean "exclusive-or", it may mean "one", it may mean "some, but not all", it may mean "neither", and/or it may mean "both", although the scope of claimed subject matter is not limited in this respect.

The module 10 pursuant to FIG. 1 suffers from several defects. In embodiments, where the module 10 and associated housing 1 are screwed down to the heatsink 5, e.g. through one or more holes 2, the resulting counterclockwise torque (e.g. in relation to the left side of the module 10) can cause a tilting of the module 10 and housing 1, and in embodiments where the thermal interface material 6 is a thermal grease or thermal foil placed at the bottom side of the module 10, e.g. at an interface in relation to the heatsink 5, tilting takes place, when a screw is tightened. As a result, the thermal interface material is displaced, moving out of an advantageous position in relation to the overall module 10. In various embodiments, the same defect can happen with respect to the right side of the module 10, e.g. clockwise torque causes the displacement if the screw-down starts on the right side of the housing 1.

In various embodiments, even if the substrate 3 is connected (e.g. soldered) to a baseplate (not shown), in contact to the heatsink 5 after screwing procedures, a similar displacement can occur, and in embodiments where the substrate 3 is a DCB substrate, the local pressure peak to the DCB can cause the substrate 3 to break, resulting in insulating failure.

One or more embodiments of the present disclosure are directed to remedying the displacement issues and other defects described herein in relation to power modules and housings, in addition to improving the connection of a power module and power module housing in relation to other components and surfaces associated therewith, including the connection of the power module housing to a heatsink. In various embodiments, one or more protrusions extend at least partially outward in relation to the overall housing and in relation to the screwing positions where the housing will be affixed to a heatsink and connect the housing to the heatsink. In various embodiments, the protrusions are a bar shape, where in various embodiments the bar shape is a heel shape; (however, this shape is given just as an example and other shapes could be used). The one or more protrusions can contain at least two portions (e.g. sub-portions) substantially perpendicular to one another forming a right-angle formation that affixes the housing to the heatsink. A hole associated with each of the one or more protrusions can be used to insert a screw therein, thus affixing the protrusions, and by extension the housing, to the heatsink. In various embodiments, this arrangement improves the mechanical stability of the power module housing (and by extension the overall power module) by reducing the tilting and other displacement effects associated with normal operation and/or other use of the device. In various embodiments, the increased stability also results in enhanced thermal transfer, in addition to improved pressure contact, between the power module housing (and by extension the overall power module) in relation to the heatsink.

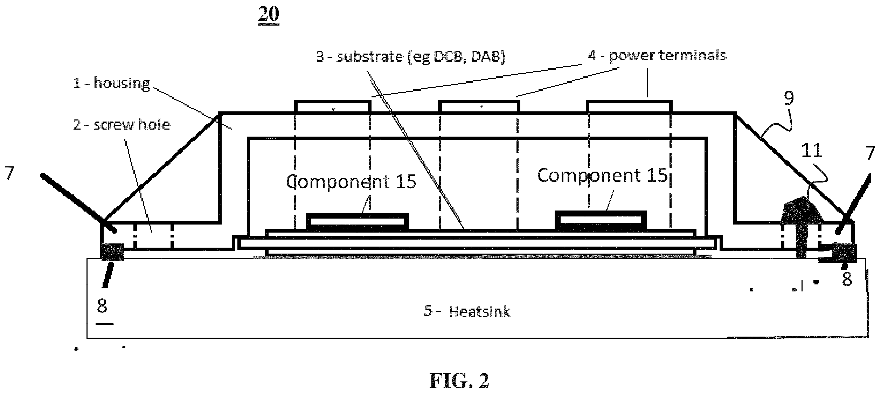

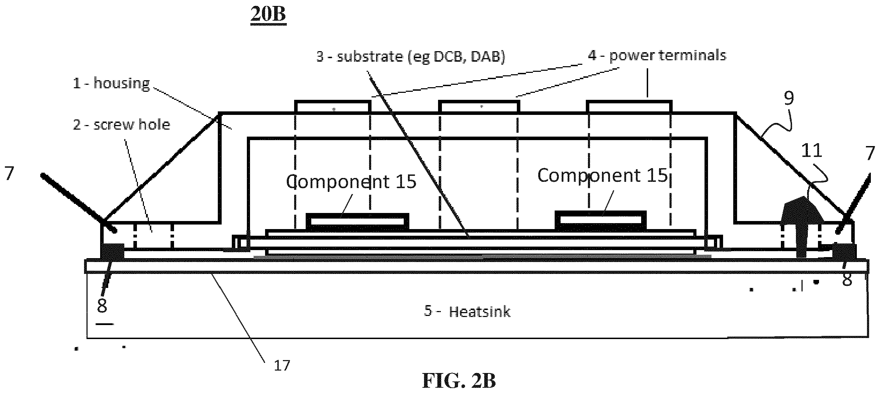

FIG. 2 illustrates a side cross-sectional view of a power module device 20 in accordance with at least one embodiment of the present disclosure. In various embodiments, the power module device 20 includes a housing 1 in contact with a heatsink 5 with one or more power terminals 4 extending into and out of the housing 1 and in contact with the substrate 3. In various embodiments, the housing 1 can be any suitable plastic or other material suitable for housing in power module devices, including but not limited to an injection mold plastic. In various embodiments (not shown), a metal baseplate may be used and may form any suitable connection with the heatsink 5 such that the heatsink 5 is beneath the metal baseplate. Any suitable method of connection between the baseplate and the heatsink can be used, and any suitable material for the baseplate may be used. In various embodiments, the heatsink 5 can be made of a thermally conductive material, such as a metal. In various embodiments, the one or more power terminals 4 can have screw holes (not shown), to be connected to exterior busbars (not shown), e.g. as dependent on the module application.

In various embodiments, the one or more power terminals 4 can be of any suitable material and of any suitable type, including but not limited to press-fit terminals and/or solderable terminals, and can be affixed to the power module device 20 using any suitable method. The power module device 20 includes a substrate 3 that is mounted to the heatsink 5 using any suitable method in relation thereto, as may be described herein or may otherwise be suitable. In various embodiments, the housing 1 may include support portions 9, as well as extensions, shown as tabs 7, which extensions extend from a central portion 1A of the housing 1, and provide screw holes 2, for affixing the housing 1 to the heat sink 5. Notably, the housing 1 may include protrusions 8, extending below the tabs 7, generally perpendicular to the plane of the tabs 7. As shown in FIG. 2, while the central portion 1A of the housing 1 and/or the tabs 7 may contact the substrate 3, the protrusions extend to contact the upper surface of heatsink 5. In various embodiments, the protrusions 8 are heel shaped, and in various embodiments, the heel shape is a bar forming a connection in relation to the housing 1 and/or the heatsink 5. In various embodiments, one or more of the protrusions 8 form a contiguous connection with respect to the housing 1, e.g. such that the protrusion portions and/or overall protrusions are actually part of the overall housing of housing 1 and/or part of the molding process utilized to form the same. In various embodiments, the protrusions 8 are not part of the housing 1, but rather are formed of material or materials physically coupled to the housing. In various embodiments, the composition of the protrusions 8 can be any suitable rigid materials and combination of materials and may be physically coupled to the housing 1.

In various embodiments, as stated and implied, the protrusions 8 are in a bottom portion of the housing 1 such that the overall protrusions contact the heatsink 5. In various embodiments the protrusions 8 may extend, partially, into the housing 1 and contact one or more components contained therein. In various embodiment, the tabs 7 may extend, partially, into the housing and contact the substrate 3 for additional support. In various embodiments, one or more protrusion portions of protrusions 8 are the same height as all or a portion of the substrate 3, e.g. the DCB and/or DAB exposure.

In various embodiments, if a baseplate is located between the substrate and the heatsink, then the protrusions 8 may directly contact the baseplate instead of the heatsink 5; alternatively, the connection to the heatsink 5 may be direct with portions of the baseplate surrounding the protrusions 8. FIG. 2B illustrates an embodiment of a power module 20B, arranged generally the same as the embodiment of power module device 20, except having a baseplate 17, disposed on the heatsink 5, so the tabs 7 contact the baseplate 17.

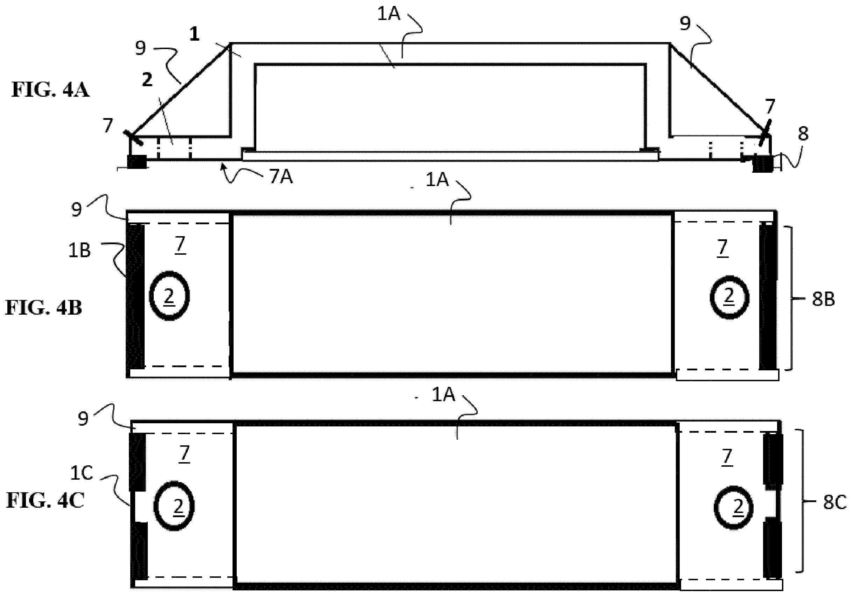

In various embodiments, as shown, one or more screws 11 can be employed through one or more screw holes 2 to affix one or more of the tabs 7 to the heatsink 5. In various embodiments, the screws 11 can be substituted for using another known fastener, and the support of one or more of the tabs 7 can be used. The one or more tabs 7 can include a screw hole 2 such that the screw or screws 11 goes through the screw hole 2 and affix the tabs 7 to the heatsink 5, which fixing by extension affixes the entirety of the housing 1 to the heatsink 5. As shown, the screw 11 goes through a screw hole 2, where the screw hole(s) 2 may be positioned at different locations within the tabs 7, as further detailed in the embodiments of FIGs. 4A-4G. In various embodiments, the one or more screws 11 can be made from any solid material including, but not limited to, metal, plastic, and other nonmetallic materials. In various embodiments, the one or more screws 11 can be made from insulating or non-insulating material. In various embodiments, material (such as thermal conductive material), may additionally be used for physically coupling the heatsink 5 to the module bottom side (substrate or baseplate).

In various embodiments, various electrical components 15, e.g. thyristors, diodes, etc. an be contained in the housing 1 or otherwise associated with the power module device 20.

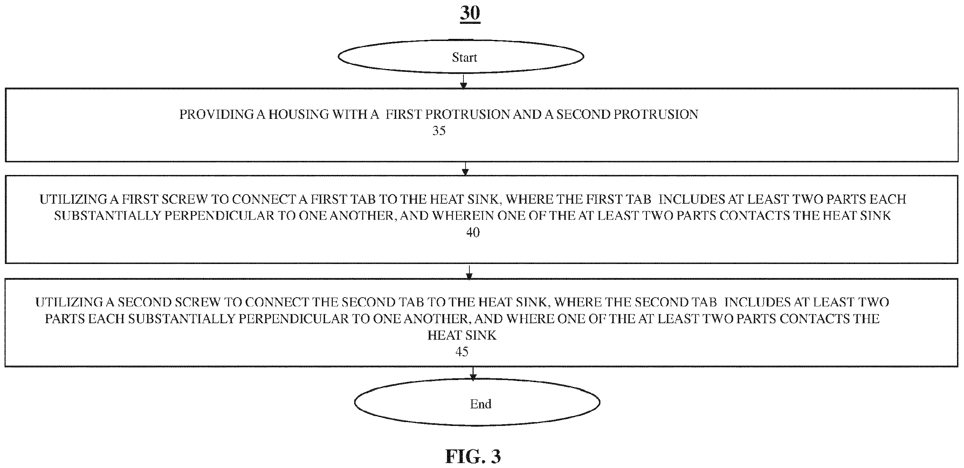

FIG. 3 illustrates a method 30 for affixing a housing of a power module device to a heatsink in accordance with at least one embodiment of the present disclosure. The method includes providing a housing with a first tab, where the first tab can be at least partially extending outwardly from the housing and in contact with a heatsink (35). The method can further include utilizing a first screw to connect the first tab to the heatsink by inserting a screw through a hole associated with the first tab, where the first tab includes at least two parts each substantially perpendicular to one another, and where one of the at least two parts is associated with the hole and another one of the at least two parts contacts the heatsink (40). In various embodiments, the shape of the first tab in relation to the housing, and in conjunction with the affixing of the protrusion to the heatsink, enhances the mechanical and thermal-transfer stability of the power module. In various embodiments, a heel or protrusion may be arranged in contact with the first tab, or as an integral portion of the first tab. The protrusion may extend from a lower side of the first tab between the main plane of the first tab and the heatsink. In various embodiments, the method can further include utilizing a second screw to connect a second tab to the heatsink, where the second tab extends at least partially outside of the housing and in contact with a heatsink, where the second tab includes a first part and a second part each substantially perpendicular to one another, and where the first part of the second tab is associated with the hole facilitating affixation with the second screw and the second part of the second tab contacts the heatsink (45). In various embodiments, the second part of the tab may be a heel or protrusion. The second screw can be inserted through a hole associated with the first part of the second tab. The affixing of the second tab with the second screw further enhances the mechanical and thermal-transfer stability of the power module device by securing the opposite end of the housing, which is already secured at the other end by the first tab and the first screw, thus further reducing mechanical instability and enhancing thermal-transfer properties associated with the power module device.

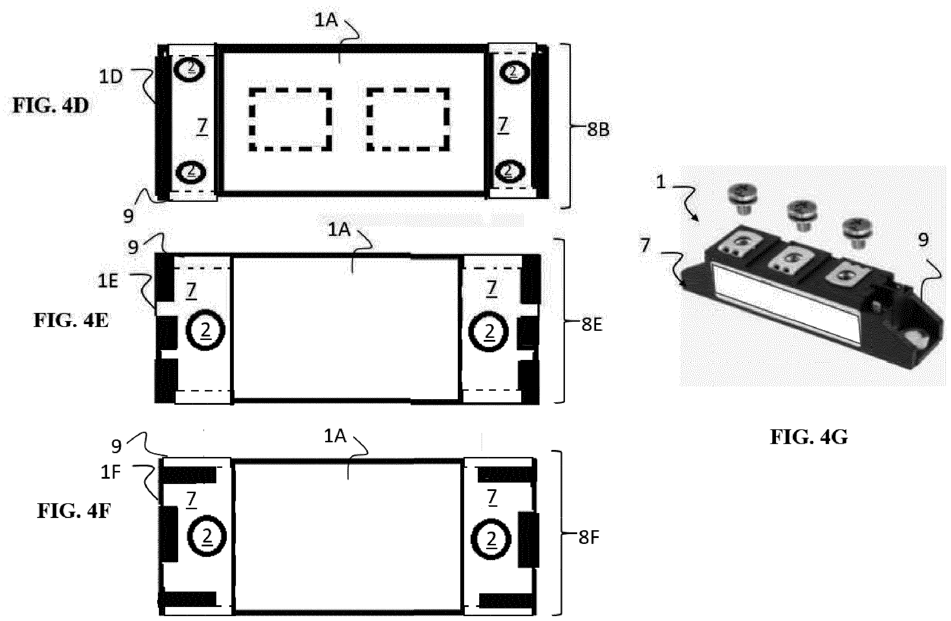

FIGs. 4A-4F illustrate variants of the housing 1 according to additional embodiments of the disclosure. In FIG. 4A, a side view is shown of the housing 1, showing general features, including the tabs 7, extending from opposite sides of the central portion 1A of housing 1. As shown, protrusions 8 are located at a distal end of tabs 7, outside of screw holes 2, and extend downwardly from the lower surface 7A of the tabs 7. FIG. 4G depicts a perspective view of the housing 1.

FIGs. 4B-4F depict a bottom plan view of variants of the housing 1, where the different embodiments may differ from one another in the configuration of the protrusions 8 and screw holes 2, for example. In FIG. 4B, the protrusions 8B are arranged as elongated stripes, located at distal ends of the tabs 7, and extending along substantially an entirety of the width of the housing 1B. This configuration may supply protection against torque tending to bend or rotate the housing when the tabs 7 are affixed to a subjacent heatsink (not shown).

In FIG. 4C, the protrusions 8C are arranged as two separate stripes, located at distal ends of the tabs 7, and extending partially along the width of the housing 1C. The omission of material in the middle between the separate stripes may not substantially affect the resistance to any torque or deformation generated when the tabs 7 are affixed to a heat sink. In both embodiments of FIG. 4B and FIG. 4C, a single screw hole 2 is located in each of tabs 7, generally in a central location, to generate symmetrical forces within the tabs 7.

In FIG. 4D, the housing 1D includes protrusions 8B that are arranged as elongated stripes, generally as described with respect to FIG. 4B. In this embodiment, two screw holes 2 are located in each of tabs 7, generally in a middle location of a tab 7, to generate symmetrical forces within the tabs 7. The provision of two screw holes may more uniformly distribute forces within the tabs 7, and in a less concentrated manner than with the use of a single screw hole.

In FIG. 4E, the protrusions 8E of housing 1E are arranged as three separate segments, located at distal ends of the tabs 7, and extending partially along the width of the housing 1E. The omission of material in the between the separate segments may not substantially affect the resistance to any torque or deformation generated when the tabs 7 are affixed to a heat sink. In this embodiment a single screw hole 2 is located in each of tabs 7, generally in a central location, to generate symmetrical forces within the tabs 7.

In FIG. 4F, the protrusions 8F of housing IF are arranged as three separate segments, located at distal ends of the tabs 7, and extending partially along the width of the housing IF, and partially along the length of the housing IF. The omission of material in the between the separate segments may not substantially affect the resistance to any torque or deformation generated when the tabs 7 are affixed to a heat sink. The provision of material extending along the length of the housing IF may also add stability against torque two different directions. In this embodiment a single screw hole 2 is located in each of tabs 7, generally in a central location, to generate symmetrical forces within the tabs 7.

While the present embodiments have been disclosed with reference to certain embodiments, numerous modifications, alterations and changes to the described embodiments are possible while not departing from the sphere and scope of the present disclosure, as defined in the appended claims. Accordingly, the present embodiments are not to be limited to the described embodiments and may have the full scope defined by the language of the following claims, and equivalents thereof.

## Claims

1. A power semiconductor device module, comprising:
a housing in contact with a substrate, a heatsink and a plurality of power terminals, wherein the housing includes a first tab, and a first protrusion, and wherein the first tab contacts the housing and the first protrusion contacts the heatsink.

2. The power semiconductor device module of claim 1 with one or more of the following: wherein the first protrusion is a heel;
wherein the plurality of power terminals are associated with an exterior portion of the housing;
wherein the substrate is enclosed by a central portion of the housing.

3. The power semiconductor device module of claim 1 or 2, further comprising:
a first screw connected extending through a first screw hole in the first tab, and connecting the first tab to the heatsink.

4. The power semiconductor device module of any of the preceding claims, wherein the first tab extends from a central portion of the housing, wherein the housing includes a second tab, extending from an opposite side of the central portion, preferably further comprising a second screw hole, disposed within the second tab and a second protrusion, extending between the second tab and the heatsink, and/or wherein the second tab and the second protrusion are substantially perpendicular in relation to one another, and/or wherein the second protrusion is a heel.

5. The power semiconductor device module of claim 4, further comprising:
a second screw extending through the second screw hole of the second tab, and connecting the second tab to the heatsink.

6. The power semiconductor device module of claim 4 or 5, wherein the first protrusion and the second protrusion include a plurality of portions.

7. The power semiconductor device module of any of the claims 4-6, wherein the first tab and the second tab include a plurality of screw holes.

8. The power semiconductor device module of any of the preceding claims 4-7, wherein the first protrusion and the second protrusion are arranged along a distal portion of the first tab and the second tab, respectively, outside of the first screw hole and the second screw hole.

9. A method for configuring a power semiconductor device:
providing a housing having a central portion, a first tab, extending laterally from the central portion, and a first protrusion, extending subjacent the first tab;
arranging the central portion over a substrate, when a heatsink is disposed subjacent the substrate; and
connecting the first tab to the heatsink using a first fastener extending through the first tab, wherein the first protrusion spaces the first tab apart from the heatsink after the connecting.

10. The method of claim 9, the housing further comprising a second tab, extending laterally from the central portion on an opposite side from the first tab, and a second protrusion, extending subjacent the second tab, the method further comprising:
connecting the second tab to the heatsink using a second fastener extending through the second tab, wherein the second protrusion spaces the second tab apart from the heatsink after the connecting.

11. The method of claim 9 or 10, wherein the first tab includes a first screw hole and the second tab includes a second screw hole, wherein the first fastener comprises a first screw, extending through the first screw hole, wherein the second fastener comprises a second screw, extending through the second screw hole.

12. The method of claim 11, wherein the first protrusion and the second protrusion are arranged in a distal portion of the first tab and the second tab, respectively, the first protrusion and the second protrusion being outside of the first screw hole and the second screw hole, respectively, with respect to the central portion of the housing.

13. A power semiconductor device module, comprising:
a heatsink;
a substrate, disposed on the heatsink;
at least one power semiconductor device, disposed on the substrate; and
a housing in contact with the substrate, wherein the housing includes a central portion, a first tab extending laterally from the central portion, and a first protrusion, extending subjacent the first tab,
wherein at least one of the central portion and the first tab are disposed in contact with the substrate.

14. The power semiconductor device module of claim 13, wherein a baseplate extends under the first tab, and the first tab is spaced apart from the baseplate by the first protrusion.

15. The power semiconductor device module of claim 13 or 14, further comprising a second tab extending laterally from the central portion, on a side opposite to the first tab, and a second protrusion, extending subjacent the second tab.
